# EUROPÄISCHE PATENTSCHRIFT

(11) **EP 0 789 507 B1**
(45) Veröffentlichungstag und Bekanntmachung des Hinweises auf die Patenterteilung: **11.09.2002**
(21) Anmeldenummer: 96120636.4
(22) Anmeldetag: 20.12.1996
(51) Int. Cl.: H05K 7/02, H05K 3/20

(54) **Eingekapseltes elektronisches Steuergerät und Verfahren zu seiner Herstellung**
Encapsulated electronic controlling device and method of fabricating the same
Dispositif électronique de contrôle encapsulé et procédé pour sa fabrication

(30) Priorität: 08.02.1996 DE 19604614; 19.06.1996 DE 19624478
(43) Veröffentlichungstag der Anmeldung: 13.08.1997
(73) Patentinhaber: Bayerische Motoren Werke Aktiengesellschaft, 80788 München (DE)
(72) Erfinder: Maier, Reinhold, 83026 Rosenheim (DE); Schmidt, Ernst, 85737 Ismaning (DE)

(56) Entgegenhaltungen:
- EP-A- 0 084 424
- EP-A- 0 548 496
- EP-A- 0 623 956
- DE-A- 4 404 986
- GB-A- 2 147 457
- US-A- 4 523 371

## Beschreibung

Die Erfindung bezieht sich auf ein elektronisches Steuergerät mit den Merkmalen, die im Oberbegriff des Patentanspruchs 1 angegeben sind, sowie auf ein Verfahren zur Herstellung eines derartigen Steuergeräts.

Ein derartiges Steuergerät und ein Verfahren zu seiner Herstellung ist aus der DE 44 04 986 A1 bekannt. Die Leiterbahnstruktur wird dabei auf einem Träger befestigt. Dabei kann der Träger auch auf das Stanzgitter aufgespritzt werden. Anschlieβend werden die elektronischen Bauelemente mit der Leiterbahnstruktur kontaktiert. Am Einsatzort, hier einem mit dem Steuergerät gesteuerten Elektromotor wird der Träger mit einer Abdeckung versehen, so dass die Leiterbahnstruktur und die Bauelemente von einem Gehäuse ummantelt sind.

Die Herstellung des bekannten Steuergeräts ist aufwendig. Zudem besitzt das Steuergerät eine geringe mechanische Stabilität, da beispielsweise das Gehäuse lediglich Schutz vor Feuchtigkeit oder Verschmutzung bietet, nicht jedoch die mechanische Stabilität des Steuergeräts erhöht. Diese wird im wesentlichen lediglich durch die Festigkeit des Trägers bestimmt, der zum Teil einseitig aufgespritzt ist.

Aus der EP 0 548 496 A1 ist ein Verfahren zur Herstellung einer Halbleiteranordnung bekannt, bei dem ein Halbleiterelement zunächst auf einer als Kühlkörper dienenden Metallplatte angeordnet wird. Die Kontakte des Halbleiterelements werden mit Anschlußenden eines Rahmens verbunden, deren andere Enden bei fertiggestellter Anordnung als Anschlußstifte dienen. Das Halbleiterelement wird zusammen mit der Metallplatte von zwei Formstückhälften umschlossen, in die zur Ausbildung einer Gehäuseeinheit ein flüssiges und aushärtbares Kunststoffmaterial eingespritzt wird. Ein mehrere elektrische Bauteile aufweisendes Steuergerät, bei dem die elektrischen Bauelemente über eine aus einem Blechstanzteil ausgebildete Leiterbahnstruktur verbunden sind, ist in der EP 0 548 496 nicht dargestellt.

Der Erfindung liegt die Aufgabe zugrunde, ein elektronisches Steuergerät der eingangs genannten Art zu schaffen, das eine hohe mechanische Stabilität besitzt und das darüber hinaus auf besonders einfache Weise herzustellen ist, wobei auch empfindliche Bauelemente beim Herstellungsprozess nicht beschädigt werden.

Die Erfindung löst diese Aufgabe durch die kennzeichnenden Merkmale des Patentanspruchs 1 bzw. hinsichtlich des Herstellungsverfahrens durch die kennzeichnenden Merkmale des Patentanspruchs 2.

Das Steuergerät besitzt ein in Kunststoff-Spritztechnik hergestelltes Gehäuse, das zu einem kompakten und gegen mechanische sowie thermische und atmosphärische Einflüsse weitgehend unempfindlichen Aufbau führt. Die Herstellung erfolgt mit Hilfe der von integrierten Schaltkreisen bekannten Spritztechnik, die einfach zu handhaben ist und die einen hohen Reifegrad besitzt. Abhängig vom verwendeten Kunststoff und/oder dem angewandten Herstellungsverfahren lassen sich die mechanischen und thermischen Eigenschaften des Steuergeräts den jeweiligen Anforderungen optimal anpassen.

Durch die Verwendung zusätzlicher Leiterbahn-Strukturabschnitte lassen sich erfindungsgemäß empfindliche Bauelemente, die während der Herstellung des Gehäuses Schaden nehmen würden, auslagern und erst nachträglich am Steuergerät befestigen. Dadurch ergibt sich die Möglichkeit, die Kunststofftechnik noch mehr den geforderten mechanischen Eigenschaften des Gehäuses anzupassen, da auf die Belastbarkeit der ansonsten innerhalb des Gehäuses angeordneten elektrischen Bauteile keine Rücksicht mehr genommen zu werden braucht.

Im Rahmen des Herstellungsverfahrens lassen sich die Kontaktteile nachträglich den jeweiligen Anforderungen anpassen. Sie können als Steck-, Löt- oder andere Anschlüsse ausgebildet werden. Neben der Möglichkeit, diese Kontakte nachträglich auszubilden, besteht auch die Möglichkeit, diese Kontakte vor dem Umspritzen der Bauteile, beispielsweise bei der Herstellung des Stanzteils selbst, bereits auszubilden.

Es ist ein Ziel der vorliegenden Erfindung, elektronische Steuergeräte zu bilden, die aus verschiedenartigen Bauteilen aufgebaut sind und die im Rahmen von mehreren Fertigungsprozessen zu einer Gesamtheit zusammengefügt werden. Dabei soll auf die mechanische Beanspruchbarkeit der Bauteile Rücksicht genommen werden und ferner die mechanische und thermische Belastung der Bauteile während des Herstellvorgangs möglichst gering gehalten werden. Dies wird durch die im Anspruch 2 angegebenen Merkmale gelöst.

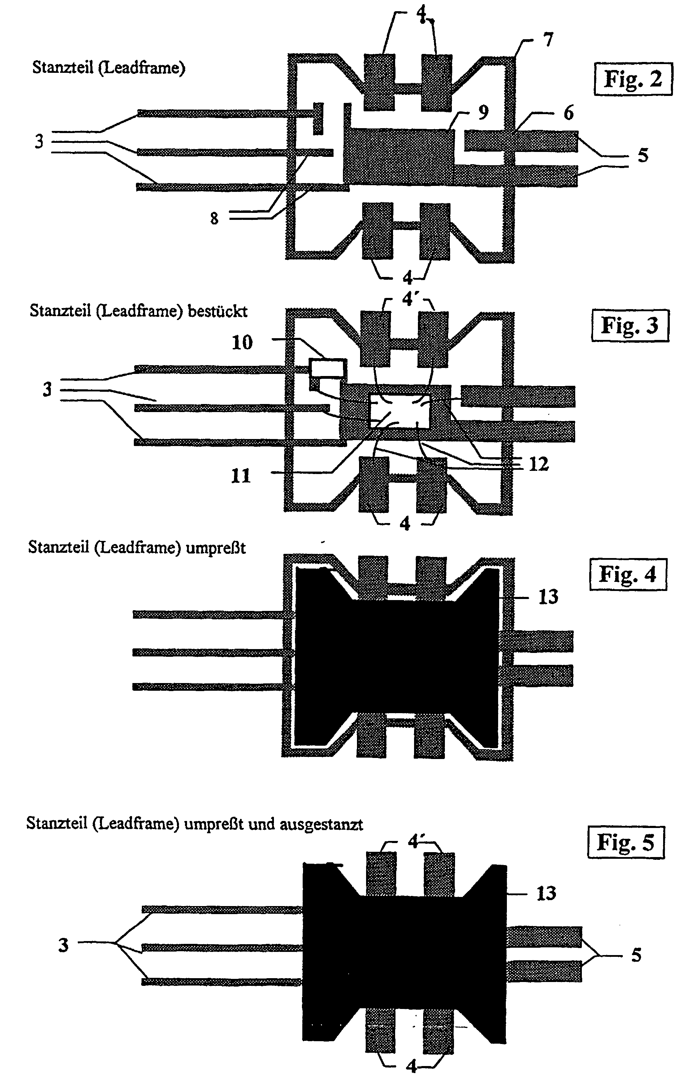

Bei dem anhand der Figuren 4 ff. näher erläuterten mehrstufigen Herstellprozeß des elektronischen Steuergeräts wird eine Folge von Behandlungsvorgängen gebildet, die ausgehend von dem Stanzgitter als mechanische Basis sich als Wechselwirkung zwischen einer Verringerung der mechanischen Stabilität, wie sie durch das Stanzgitter gegeben wird, bei gleichzeitigem Aufbau einer durch die Umspritzvorgänge erzeugten alternativen mechanischen Stabilität besteht. Diese Stabilität beruht auf den beim ersten und beim zweiten Umspritzvorgang gebildeten Körpern aus plastischem Material, die zusammen mit dem dann jeweils noch verbleibenden Teilen des Stanzgitters für eine hinreichende Festigkeit des Steuergeräts sorgen. Gleichzeitig wird mit den Umspritzvorgängen ein mechanischer, thermischer und chemischer Schutz der umspritzten Bauteile erzielt sowie die Kontakte zwischen den Bauteilen und den Stanzgitterstrukturen stabilisiert.

Für das Erreichen der genannten Ziele eignet sich für den ersten Umspritzvorgang besonders ein Duroplast und für den zweiten Umspritzvorgang ein Thermoplast. Duroplaste werden unter Druck in ein Werkzeug eingefüllt; die Molekülketten vernetzen bei höherer Temperatur. Diese Materialien sind unter Handelsnamen wie "NITTO 10-2" bekannt und eignen sich zur direkten Umhüllung von Silizium-Halbleiter durch minimalen Gehalt an Verunreinigungen, durch gute thermische Eigenschaften und gute mechanische Eigenschaften; die Möglichkeiten der Formgestaltung sind jedoch begrenzt.

Thermoplaste entstehen durch Abkühlung einer Schmelze. Sie sind unter Handelsnamen wie "Hostalen" bekannt. Sie sind nicht zum direkten Umhüllen von Halbleitern geeignet, können aber durch entsprechende Ausbildung der Werkzeuge komplizierte mechanische Formen wie Gehäuse mit angespritztem Steckerkragen bilden.

Die Erfindung ist anhand eines in der Zeichnung dargestellten Ausführungsbeispiels weiter erläutert. Es zeigt
- Figur 1: ein elektronisches Steuergerät in perspektivischer Darstellung nach Fertigstellung,
- Figur 2 bis 5: einzelne Stufen des Fertigungsverfahrens für das Steuergerät von Figur 1,
- Figur 6: eine erfindungsgemäße Variante des Steuergeräts von Figur 1 in Draufsicht,
- Figur 7: das Steuergerät von Figur 6 im verbauten Zustand und
- Figur 8: eine weitere Ausführungsvariante des Steuergeräts in Seitenansicht.
sowie anhand von Figur 9 bis 16 die einzelnen Stufen eines mehrstufigen Herstellungsverfahren für ein elektronisches Steuergerät.

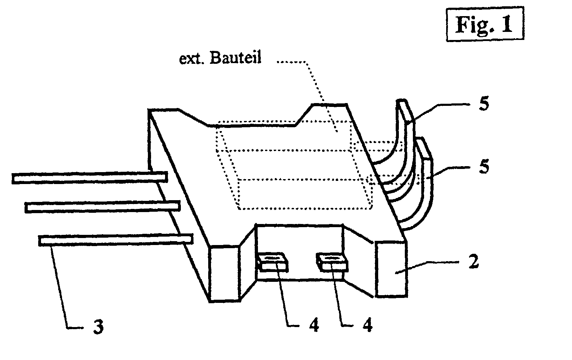

Das in Figur 1 dargestellte elektronische Steuergerät besteht im wesentlichen aus einem Gehäuse 2, aus dem Steckkontakte 3, Anschlußkontakte 4 und 4'(Figur 2) sowie weitere Anschlußkontakte 5 hervorstehen. Es dient beipielsweise dazu, einen Schrittmotor zu steuern (Figur 7).

Das Steuergerät 1 wird hergestellt aus einem Blechstanzteil 6, das aufgebaut ist aus einem Hilfsrahmen 7 und mit diesem verbundenen Kontaktteilen 3, 4, und 5 sowie den Kontakten 4 entsprechenden korrespondierenden Kontaktteilen 4', Leiterbahnabschnitten 8 sowie einem zentralen Träger 9. Nach Herstellung des Blechstanzteils 6 werden elektronische Bauteile wie ein Chipkondensator 10 und ein Mikroprozessor 11 an den eingezeichneten Stellen fixiert und über Bonddrähte mit den zugehörigen Anschlüssen 3, 4, 4' und 5 verbunden (Figur 3).

Anschließend wird das Stanzteil mit Kunststoff umgeben und das Gehäuse 13 gebildet (Figur 4). Dabei wird eine an sich bekannte Kunststoff-Spritztechnik angewandt.

Anschließend wird der Hilfsrahmen 7 wie dargestellt entfernt. Die Anschlüsse 3, 4, 4' und 5 bleiben stehen und können beispielsweise nachbehandelt werden. Sie können beispielsweise verlötet oder wie bei den Anschlüssen 4 und 4' angedeutet an der eingezeichneten Stelle ausgestanzt und so mit Öffnungen versehen werden.

Das so gebildete Steuergerät ist mechanisch stabil. Die Bauteile sowie die zu den Anschlüssen führenden Bonddrähte sind gegen äußere Einflüsse thermischer, mechanischer und chemischer Art völlig geschützt.

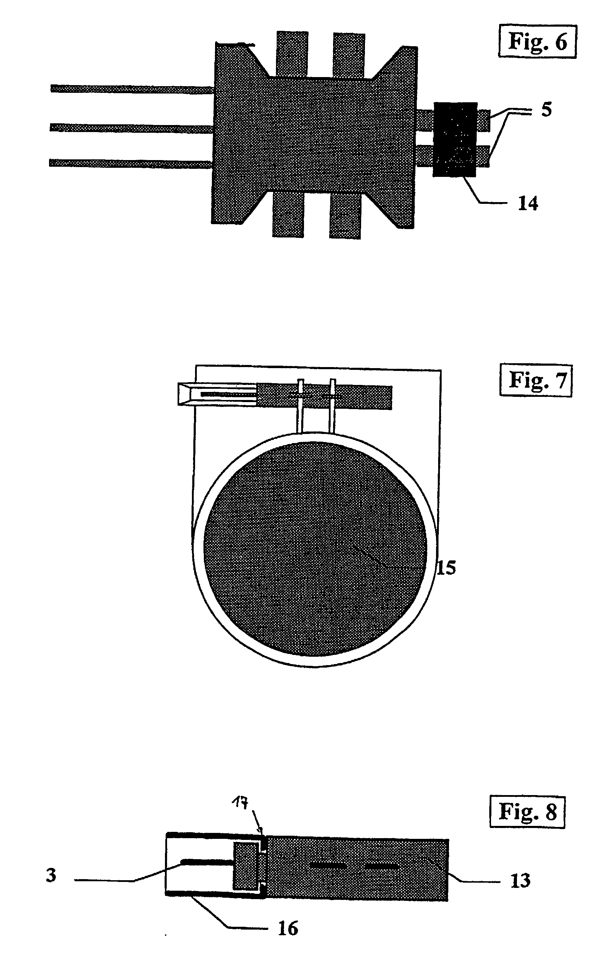

In Figur 6 ist gezeigt, wie die beiden Anschlüsse 5 dazu verwendet werden, ein ausgelagertes Bauteil, beispielsweise einen Resonator 14 zu tragen. Dieser wird nach der Herstellung des Gehäuses 13 angeordnet. Hierbei können die Anschlüsse 5 nach oben gebogen werden (Figur 1).

Das so gebildete Steuergerät kann beispielsweise verwendet werden, um einen Schrittmotor 15 zu steuern. Es ist in an sich bekannter Weise auf der Oberseite des Motors angeordnet und über die Anschlüsse 4 und 4' mit dem Motor 15 verbunden (Figur 7).

Ergänzend kann für beispielsweise die Steckkontakte 3 ein Gehäuse 16 vorgesehen sein, das nachträglich mit dem Körper 13 verbunden werden kann. Hierzu besitzt der Körper 13 beispielsweise dann eine Einschnürung 17, in die das SteckerGehäuse 16 eingeklippst wird. Die Anschlüsse 3 sind dann zusätzlich geschützt und ermöglichen einen problemlosen Anschluß eines nicht gezeigten Steckers am elektronischen Steuergerät 1. Auf diese Weise ergibt sich ein elektronisches Steuergerät, das einfach im Aufbau und in der Herstellung ist und das dennoch eine hohe mechanische und thermische Stabilität besitzt.

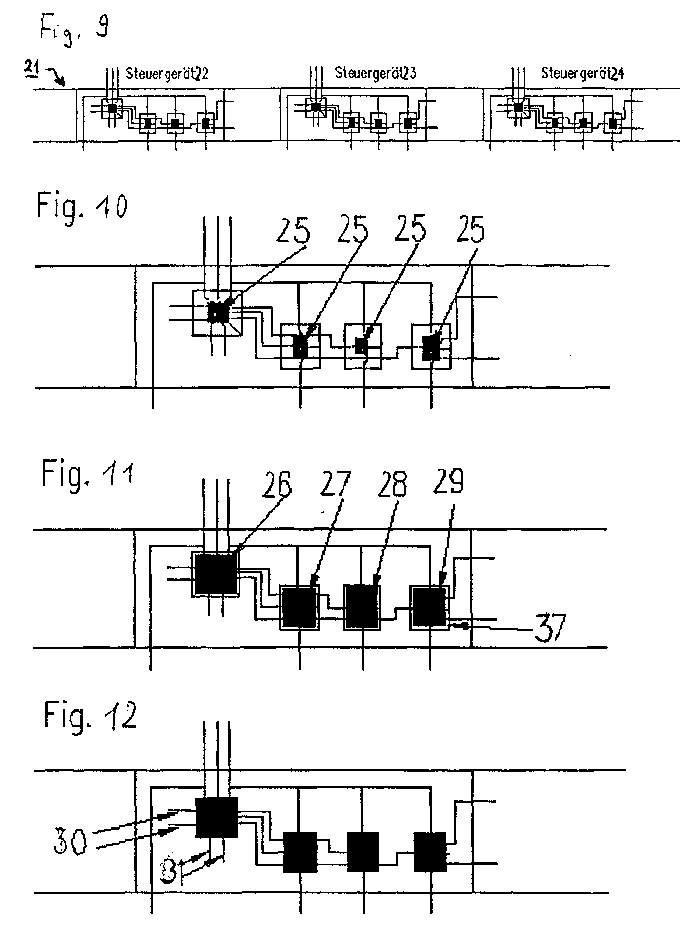

Figur 9 zeigt ein Stanzgitter 21, das zur Herstellung von insgesamt drei gleichartigen elektronischen Steuergeräten 22 bis 24 dient. Das Stanzgitter für jedes der Steuergeräte ist in Figur 2 im Detail dargestellt.

Figur 10 zeigt den nächsten Schritt des Herstellungsverfahrens. Dabei werden an einzelnen Knotenpunkten des Stanzgitters IC's 25 aufgebracht und mit Teilen des Stanzgitters gebondet.

Figur 11 zeigt das Steurgerät nach Ausführen des ersten Umspritzvorganges. Dabei werden die Teile des Stanzgitters zusammen mit den darauf angeordneten IC's mit einem Duroplast umspritzt. An jeweils vier Stellen werden dadurch einzelne Körper 26 bis 29 gebildet, die weiterhin über Teile des Stanzgitters miteinander verbunden sind.

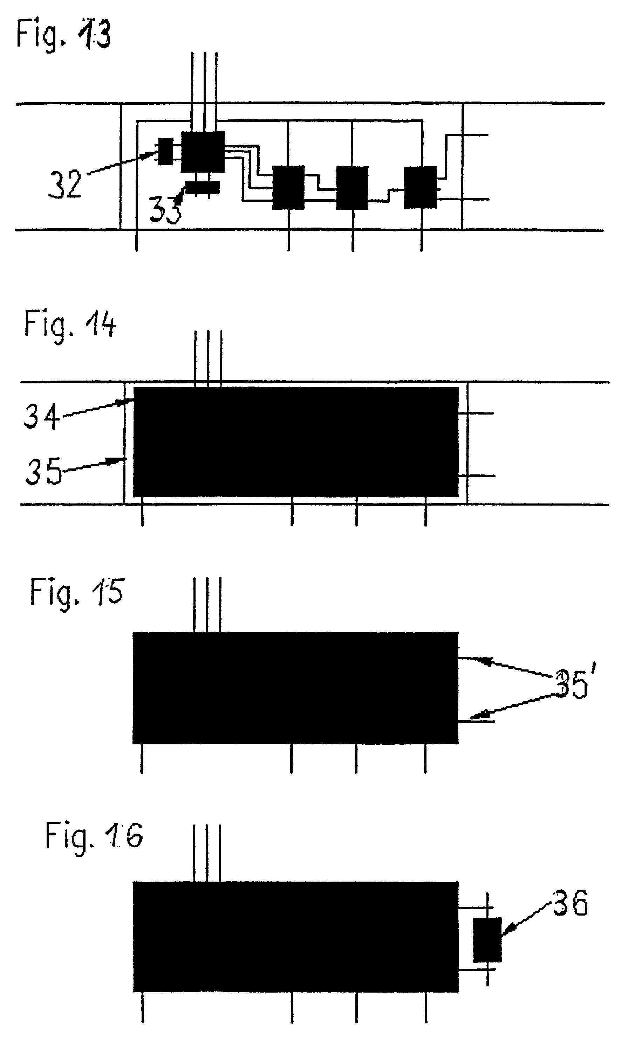

Beim nächsten Behandlungsvorgang, dessen Ergebnis in Figur 12 dargestellt ist, wird der Stanzgitterrahmen, soweit er die einzelnen Körper umgibt und im Rahmen der in Figur 10 und Figur 11 dargestellten Fertigungsstufen mit mechanischer Stabilität versieht, aufgestanzt. Es sind dann zwischen den Körpern 26 bis 29 nur noch die Stanzgitterstrukturen vorhanden, die neben der mechanischen Stabilität auch für die elektrische Verbindung zwischen den in den Körpern 26 bis 29 enthaltenen elektronischen Bauteilen sorgen. Ferner sind freibleibende Enden 30 und 31 der Stanzgitterstruktur vorgesehen, die in einem weiteren Behandlungsvorgang mit gehäusten Bauteilen 32 und 33 bestückt werden. Das Ergebnis diese Bestückungsvorgangs ist in Figur 13 dargestellt.

Der so gewonnene Aufbau aus mechanischen und elektrisch miteinander verbundenen Körpern mit darin enthaltenen elektronischen Bauteilen sowie ausgelagerten gehäusten Bauteilen bestehende Aufbau wird nunmehr in einem weiteren Umspritzvorgang mit Thermoplast umspritzt. Es werden die in Figur 14 dargestellten Steuergeräte 34 gebildet, die noch von einem Halterrahmen 35 umgeben sind.

Der Halterrahmen 35 wird in einem anschließenden Behandlungsvorgang abgestanzt. Das Ergebnis ist aus Figur 15 zu ersehen.

Anschließend kann an freien Enden 35' des Stanzgitters ein zusätzliches Bauelement 36 angeordnet und elektrisch mit den Enden 35' verbunden werden (Figur 16).

Nicht im einzelnen dargestellt sind zusätzliche Behandlungsvorgänge, die im Rahmen der Fertigungsstufen vorgesehen sind und bei denen das Stanzgitter getrimmt wird. Es ist beispielsweise in Figur 12 durch einen Pfeil 37 zu erkennen, bei der ein hervorstehendes Teil des Stanzgitters abgenommen wird.

Anhand der Figuren ist erkennbar, mit wie wenig Behandlungsschritten ein elektronisches Steuergerät hergestellt wird, dass ein Höchstmaß an mechanischer und elektrischer Stabilität bietet.

## Patentansprüche

1. Elektronisches Steuergerät mit einem Gehäuse, mit einem Blechstanzteil für eine Leiterbahnstruktur, mit der darauf angeordnete elektrische Bauteile miteinander verbunden sind, und mit aus dem Blechstanzteil ausgeformten und aus dem Gehäuse hervortretenden Kontaktteilen,
**dadurch gekennzeichnet,**
**daß** das Gehäuse (13), welches in Kunststoff-Spritztechnik hergestellt ist, die elektrischen Bauteile (10, 11) und das Blechstanzteil (6) mit Ausnahme der äußeren Enden der Kontaktteile (3, 4, 4', 5) vollständig umgibt, daß weitere Leiterbahnstrukturen (5) aus dem Gehäuse (13) hervortreten, an denen ausgelagerte Bauteile (14) befestigt sind und daß weiter freibleibende Enden der Gitterstruktur mit zusätzlichen Bauelementen (36) bestückt und elektrisch verbunden werden können.

2. Verfahren zum Herstellen eines elektronischen Steuergeräts nach Anspruch 1,
**dadurch gekennzeichnet,**
**daß** das Stanzgitter mit elektronischen Bauteilen bestückt wird und die Bauteile mit Teilen des Stanzgitters elektrisch verbunden werden, daß anschließend ein Körper durch Umspritzen der Bauteile mit plastischem Material gebildet wird, wobei ein im Blechstanzteil (6) ausgebildeter Hilfsrahmen (7) beim Herstellen des Gehäuses (13) nicht umspritzt und anschließend weitgehend entfernt wird, und daß weiter freibleibende Enden der Gitterstruktur mit zusätzlichen Bauelementen bestückt und elektrisch verbunden werden können.

3. Verfahren nach Anspruch 2,
**dadurch gekennzeichnet,**
**daß** die Kontaktteile (3, 4, 4', 5) nachträglich im Rahmen eines Umformprozesses fertiggestellt werden.

4. Verfahren nach Anspruch 2 oder 3,
**dadurch gekennzeichnet,**
**daß** die Bauteile mit dem Körper erneut mit plastischem Material unter Freilassung einer äußeren Rahmenstruktur des Stanzgitters einem Umspritzvorgang unterzogen werden und daß die Rahmenstruktur mit zusätzlichen Bauelementen bestückt und/oder abgestanzt wird.

5. Verfahren nach Anspruch 4,
**dadurch gekennzeichnet,**
**daß** als plastisches Material für den Körper ein Duroplast verwendet wird.

6. Verfahren nach Anspruch 4 oder 5,
**dadurch gekennzeichnet,**
**daß** als plastisches Material für den erneuten Umspritzvorgang ein Thermoplast verwendet wird.

7. Verfahren nach einem der Ansprüche 4 bis 6,
**dadurch gekennzeichnet,**
**daß** das Stanzgitter im Anschluß an die Umspritzvorgänge getrimmt wird.

## Claims

1. An electronic control unit with a case, with a sheet metal stamped part for a lead frame structure, with which the electrical components arranged upon it are connected and with contact rails formed from the stamped sheet metal part and extending outside the case,
**characterised in that**,
the case (13), which is produced in plastics material injection moulding technique, completely encapsulates the electrical components (10,11) and the stamped sheet metal part (6) with the exception of the outer ends of the contact parts (3, 4, 4', 5), and that further conductor track structures (5) extend out from the case (13), onto which external components are fastened, and that further ends of the lead frame structure, remaining free, can be loaded and electrically connected with additional components (36).

2. A method for the production of an electronic control unit according to Claim 1,
**characterised in that**
the stamped lead frame is loaded with electronic components and the components are electrically bonded to parts of the stamped lead frame, that then a body is formed by the extrusion coating of the components with plastics material, whereby an auxiliary frame (7) formed in the sheet metal stamped part (6) is not extrusion coated and is then largely removed and that further ends of the lead frame structure remaining free, can be loaded with additional components and electrically bonded to them.

3. A method according to Claim 2,
**characterised in that**,
the contact parts (3, 4, 4', 5) are fabricated retrospectively in the framework of a conversion process.

4. A method according to Claim 2 or Claim 3,
**characterised in that**,
the components and the body are again subjected to an extrusion coating process with plastics material omitting the outer frame structure of the stamped lead frame and that the frame structure is loaded with additional components and/or pressed off.

5. A method according to Claim 4,
**characterised in that**,
a pressure setting plastics material is used as the plastics material for the body.

6. A method according to Claim 4 or Claim 5,
**characterised in that**,
a thermoplastic material is used as the plastics material for the renewed extrusion coating process.

7. A method according to one of the Claims 4 to 6,
**characterised in that**,
the stamped lead frame is trimmed on the conclusion of the extrusion coating processes.

## Revendications

1. Appareil de commande électronique comprenant un boîtier recevant une pièce estampée pour une structure de chemin conducteur pour recevoir des composants électriques à relier entre eux ainsi que des pièces de contact formées dans la pièce et sortant du boîtier,
**caractérisé en ce que**
le boîtier (13) fabriqué en injection avec de la matière plastique entoure complètement les composants électriques (10, 11) et la pièce estampée (6) à l'exception des extrémités extérieures des pièces de contact (3, 4, 4', 5), et d'autres chemins conducteurs (5) sortent du boîtier (13) sur lesquels sont fixées des pièces déportées (14), et
d'autres extrémités laissées libres de la structure en forme de grille reçoivent des composants supplémentaires (36) pour être reliées électriquement à ceux-ci.

2. Procédé de fabrication d'un appareil de commande électronique selon la revendication 1,
**caractérisé en ce que**
la grille estampée est garnie de composants électroniques qui sont reliés électriquement à des parties de la grille et ensuite on forme par injection autour des pièces avec de la matière plastique un corps, sans enrober un cadre auxiliaire (7) réalisé dans la pièce estampée (6) lors de la fabrication du boîtier (13), et qui ensuite est enlevé, et les extrémités laissées libres de la structure en forme de grille peuvent recevoir des composants supplémentaires reliés électriquement.

3. Procédé selon la revendication 2,
**caractérisé en ce qu'**
on fabrique les pièces de contact (3, 4, 4', 5) ultérieurement au cours d'une opération de transformation.

4. Procédé selon l'une quelconque des revendications 2 ou 3,
**caractérisé en ce qu'**
on soumet une nouvelle fois les pièces avec le corps en matière plastique à une injection en laissant libre la structure extérieure du cadre de la grille estampée, et cette structure de cadre est équipée et/ou estampée avec des composants supplémentaires.

5. Procédé selon la revendication 4,
**caractérisé en ce que**
la matière plastique pour le corps est une matière thermodurcissable.

6. Procédé selon l'une quelconque des revendications 4 ou 5,
**caractérisé en ce que**
la matière plastique pour la seconde opération d'injection est une matière thermoplastique.

7. Procédé selon l'une quelconque des revendications 4 à 6,
**caractérisé en ce qu'**
on règle la grille estampée après les opérations d'injection.
